# EUROPEAN PATENT SPECIFICATION

(11) **EP 0 477 537 B1**
(45) Date of publication and mention of the grant of the patent: **29.12.1997**
(21) Application number: 91114102.6
(22) Date of filing: 22.08.1991
(51) Int. Cl.: H03K 17/28, H03K 4/00, H03K 4/56

(54) **Timing generator**
Zeitgeber
Générateur de temporisation

(30) Priority: 28.09.1990 JP 259607/90; 01.07.1991 JP 160414/91; 20.02.1991 JP 26197/91
(43) Date of publication of application: 01.04.1992
(73) Proprietor: Yokogawa Electric Corporation, Tokyo 180 (JP)
(72) Inventor: Imamura, Makoto, Akishima-shi, Tokyo 196 (JP); Kohno, Jun, Koganei-shi, Tokyo 184 (JP); Arasawa, Hisaki, Kodaira-shi, Tokyo 187 (JP)
(74) Representative: Henkel, Feiler, Hänzel & Partner

(56) References cited:
- DE-A- 4 002 328
- TOUTE L'éLECTRONIQUE no. 545, June 1989, PARIS, FR page 50; 'La Conversion Tension Fréquence'
- PATENT ABSTRACTS OF JAPAN vol. 12, no. 390 (P-772)18 October 1988 & JP-A-63 133 071

## Description

### BACKGROUND OF THE INVENTION

### 1. Field of the Invention

The present invention relates to a timing generator capable of delaying its input timing signal in such a way that the delay time can be set with a high accuracy and a high resolution.

### 2. Description of the Prior Art

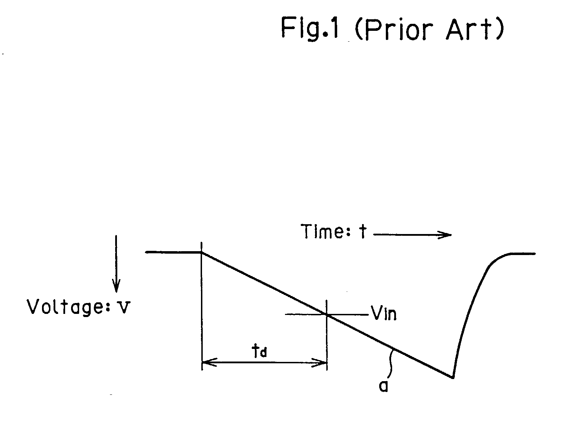

Heretofore, timing generators have been used to accurately determine the timing of measurements made, for example, by systems for inspecting digital LSIs. Fig. 1 is a waveform diagram illustrating the operation of a first kind of such conventional timing generator. This generator converts incoming digital values into corresponding analog output Vᵢₙ, and compares this analog output with a ramp waveform α to obtain a delay time t_{d}. A second kind of conventional timing generator selects some of a number of delay gates.

In the first kind of conventional generator, it is required that the ramp waveform have linearity. Also, a capacitor of high quality is needed. In addition, the repetition frequency is limited by the ramp waveform. Furthermore, the circuit configuration is complex, because a high-speed D/A converter is necessitated.

The second kind of conventional generator has a large-scale configuration. It is necessary to make uniform the differences between the successively switched delay amounts. It is difficult to obtain good linearity and monotonicity.

### SUMMARY OF THE INVENTION

In view of the foregoing problems with the prior art techniques, it is an object of the present invention to provide a timing generator which is simple in structure, shows good linearity, and can operate at a high speed.

The above object is achieved in accordance with the teachings of the invention by a timing generator comprising the features recited in claim 1.

In one embodiment of the invention, the setting means is a control circuit which turns on and off the amplifier in response to the input data.

In another embodiment of the invention, the setting means is a digital-to-analog converter which controls the amplitude of the output signal from the amplifier in response to the input data.

Other objects and features of the invention will appear in the course of the description thereof which follows.

### BRIEF DESCRIPTION OF THE DRAWINGS

Fig. 1 is a waveform diagram illustrating the operation of a conventional timing generator;
Fig. 2 is a block diagram of a timing generator according to the invention;
Fig. 3 is a timing chart illustrating the operation of the generator shown in Fig. 2;
Fig. 4 is a circuit diagram of a specific example of a part of the generator shown in Fig. 2;
Fig. 5 is a circuit diagram of a specific example of another part of the generator shown in Fig. 2;
Fig. 6 is a block diagram of another timing generator according to the invention;
Fig. 7 is a timing chart illustrating the operation of the generator shown in Fig. 6;
Fig. 8 is a circuit diagram of a specific example of a part of the generator shown in Fig. 6;
Fig. 9 is a block diagram of a first specific example of another part of the generator shown in Fig. 6;
Fig. 10 is a circuit diagram of a second specific example of a further part of the generator shown in Fig. 6;
Fig. 11 is a block diagram of a circuit using a timing generator according to the invention; and
Fig. 12 is a timing chart illustrating the operation of the circuit shown in Fig. 11.

### DETAILED DESCRIPTION OF THE PREFERRED EMBODIMENTS

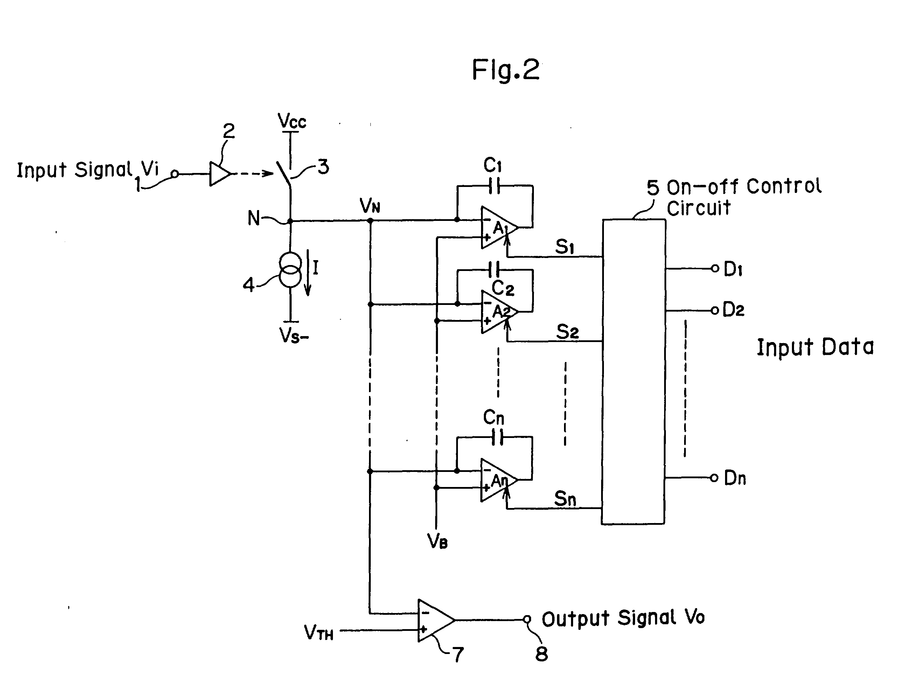

Referring to Fig. 2, there is shown a timing generator embodying the concept of the present invention. This generator comprises an input terminal 1, a buffer amplifier 2, a switch 3, a constant current source 4, a plurality of differential amplifiers A₁ - Aₙ which can be turned on and off from the outside, a plurality of capacitors C₁ - Cₙ , a comparator 7, a control circuit 5, and an output terminal 8. A timing signal Vᵢ is applied to the input terminal 1 and then supplied to the buffer amplifier 2. The switch 3 is turned on and off by the output signal from the buffer amplifier 2. A positive voltage source applies a first voltage V_{CC} to one end of the switch 3. One end of the constant current source 4 is connected with the other end of the switch 3. A negative voltage source applies a second voltage V_{S-} to the other end of the current source 4. All the inverting input terminals of the differential amplifiers A₁ - Aₙ are connected with the node N of the switch 3 and the current source 4. A third voltage source impresses a voltage V_{B} on all the non-inverting input terminals of the amplifiers A₁ - Aₙ . The capacitors C₁-Cₙ form capacitances via which the output terminals of the amplifiers A₁ - Aₙ are connected with their respective inverting input terminals. The comparator 7 compares the voltage developed at the interconnected inverting input terminals of the amplifiers A₁-Aₙ with a fourth voltage V_{TH}, and produces a delayed timing signal at the output terminal 8. The control circuit 5 receives input data D₁-Dₘ and delivers control signals S₁-Sₙ in response to the input data to turn on and off the amplifiers A₁-Aₙ . The control circuit 5 forms a setting means for setting the equivalent input capacitance produced in the linear region of each amplifier according to the input data. Each amplifier consists of a combination of each amplifier Aᵢ and each capacitance Cᵢ . The first voltage V_{CC} , the second voltage V_{S-} , the third voltage V_{B} , and the fourth voltage V_{TH} have the following relation:${\text{V}}_{\text{CC}} {\text{> V}}_{\text{B}} {\text{> V}}_{\text{TH}} {\text{> V}}_{\text{S-}}$

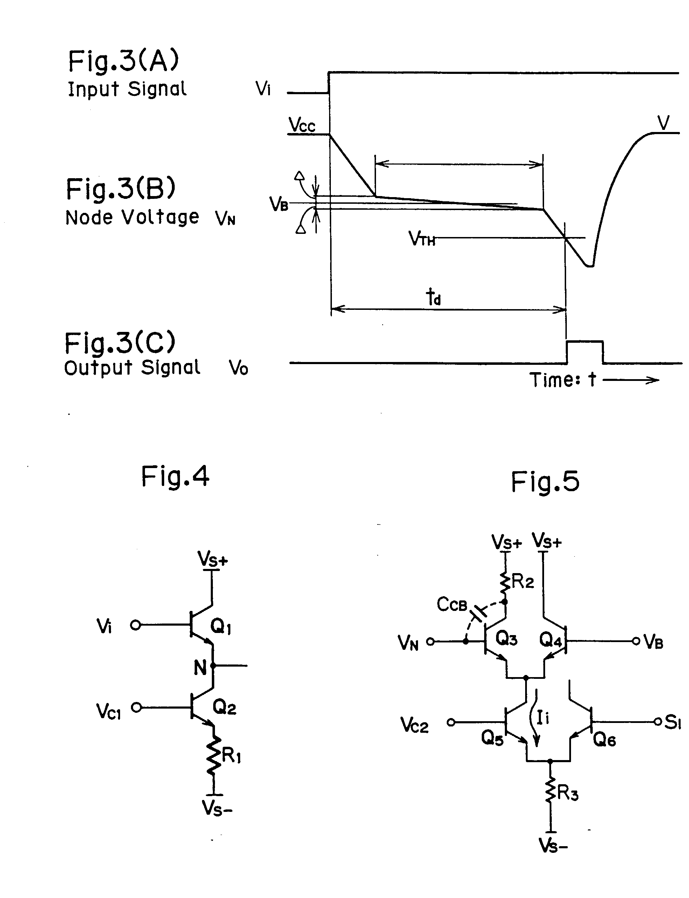

The operation of the timing generator constructed as described above is next described by referring to the timing chart of Fig. 3. The points at which the amplifiers A₁-Aₙ are turned on and off have been previously set by the control signals S₁-Sₙ produced from the control circuit 5 according to the input data D₁-Dₘ which represent delay times. When the amplifiers A₁-Aₙ are all turned off, the equivalent input capacitance C_{off} applied to the node N is given by${\text{C}}_{\text{off}} {\text{= C}}_{\text{S}} {\text{+ Σ C}}_{\text{i}}$ where Cₛ is the stray capacitance. Therefore, when the input timing signal Vᵢ (Fig. 3(A)) turns off the switch 3, the capacitance C_{off} is electrically discharged by the constant current source 4. The voltage at the node N varies with time as given by${\text{V}}_{\text{N}} {\text{= V}}_{\text{CC}} {\text{- (I /C}}_{\text{off}} \text{) · t}$ When the relation V_{N} = V_{TH} is reached, the output signal from the comparator 7 goes high. At this time, the delay time t_{d} is given by${\text{t}}_{\text{d}} {\text{= ( V}}_{\text{CC}} {\text{- V}}_{\text{TH}} {\text{)C}}_{\text{off}} \text{/ I}$

When any one Aᵢ of the amplifiers A₁-Aₙ is turned on, the voltage V_{N} at the node behaves in the manner specified by equations (2) and (3) within the region in which the amplifier A, saturates. In the linear input region of the amplifier which is located in the neighborhood of the voltage V_{B} and given by${\text{V}}_{\text{B}} {\text{+ Δ > V}}_{\text{B}} {\text{> V}}_{\text{B}} \text{- Δ}$ the amplifier Aᵢ and the capacitor Cᵢ together operate as a Miller integrator. It follows that a capacitance is added to the node N. This is because the amplitude of the output signal from the amplifier Aᵢ swings by V_{H} - V_{L} , permitting electric charge Cᵢ (V_{H} - V_{L} ) to flow into the corresponding capacitor Cᵢ . Since the charge is supplied from the current source 4, the electric current I is consumed by the capacitance during a period that is equivalent to${\text{t}}_{\text{di}} {\text{= C}}_{\text{i}} {\text{(V}}_{\text{H}} {\text{- V}}_{\text{L}} \text{) / I}$ The delay time t_{d} is increased accordingly. Therefore, the delay time (Fig. 3(B)) at this time is given by${\text{t}}_{\text{d}} {\text{= (V}}_{\text{CC}} {\text{- V}}_{\text{TH}} {\text{)C}}_{\text{off}} {\text{/ I + Σ { (V}}_{\text{H}} {\text{- V}}_{\text{L}} {\text{)/I } · C}}_{\text{i}} \text{· pi}$ When the amplifier Aᵢ is operating, pi = 1. When the amplifier Aᵢ is not operating, Pi = 0. Thus, the equivalent input capacitance produced in the linear region of the amplifier is set according to the input data. As a result, a delayed timing signal V₀ (Fig. 3(C)) whose delay time is controlled appears at the output terminal 8.

Fig. 4 shows a specific example of the switch 3 and the constant current source 4 included in the timing generator shown in Fig. 2. It is to be noted that like components are indicated by like reference numerals in various figures. A transistor Q₁ forms the switch 3. A transistor Q₂ and a resistor R₁ together form the constant current source 4. The current value of the current source is controlled by a voltage V_{c1}.

Fig. 5 shows a specific example of the amplifier Aᵢ included in the timing generator shown in Fig. 2. A load resistor R₂, transistors Q₃ and Q₄ together form a differential input circuit. A transistor Q₅ and a resistor R₃ together form a constant current source whose current value is controlled by a voltage V_{c2}. A transistor Q₆ forms a circuit that turns on and off this current source. A positive voltage source V_{S+} is connected with the transistor Q₃ via the load resistor R₂. The positive voltage source V_{S+} is also connected directly with the transistor Q₄. A negative voltage source V_{S-} is connected with the transistors Q₅ and Q₆ via the resistor R₃. Stray capacitance C_{CB} exists between the collector and the base of the transistor Q₃. The capacitor Cᵢ already described in connection with Fig. 2 can be omitted by using this stray capacitance. Let Iᵢ be the constant current flowing through the transistor Q₅. The amplitude (V _{H} - V_{L} ) of the output signal from this amplifier is given by Iᵢ · R₂. A high resolution can be easily obtained by weighting the Miller capacitance by any of the following four methods.
(a) The constant current value Iᵢ is weighted with 1, 2, 4, etc. while maintaining the load resistance R₂ and the stray capacitance C_{CB} constant.
(b) The load resistance R₂ is weighted with 1, 2, 4, etc. while maintaining the stray capacitance C_{CB} and the current value Iᵢ constant.
(c) The constant current value Iᵢ and the load resistance R₂ are maintained constant. Transistors are connected in parallel. The stray capacitance C_{CB} is weighted with 1, 2, .4, etc.
(d) The above methods (a)-(c) are used in combination.

The amplifier shown in Fig. 5 can be turned on and off by turning on and off the current source. This is turned on and off when signal S, goes OFF and ON, respectively.

This timing generator is simple in structure. As an example, in order to realize 32 different stages of delay, only 5 differential amplifiers are needed. Consequently, low consumption of electric power and low cost can be accomplished.

In the conventional method (Fig. 1) using a ramp waveform, if the delay time t_{d} is set large, the inclination of the ramp waveform becomes less steep. The result is that the apparatus is vulnerable to noise. In the present invention, a steep inclination (Fig. 3(B)) is regained subsequent to the linear region and, therefore, the novel apparatus is immune to noise.

In the conventional method (Fig. 1), the period of the ramp waveform is constant and so only a given repetition frequency is possible. In accordance with the invention, the repetition frequency can be set to large values where the delay time is short. In the linear region, the delay time is determined by the amount of electric charge. Since the process of integration does not affect the linearity, the linearity is high. Additionally, the novel generator can be easily fabricated as an IC, because no LC circuit is used.

The full scale can be readily readjusted by varying the constant current value Iᵢ (Fig. 5) or the current I (Fig. 2), which would have been impossible to realize by the prior art gate delay system.

In the example shown in Fig. 2, Aᵢ consists of a differential amplifier, but Aᵢ is not limited to this kind of amplifier. Rather, any arbitrary amplifier having an inverting input terminal can be employed. Where high-speed operation is not needed, operational amplifiers may be utilized.

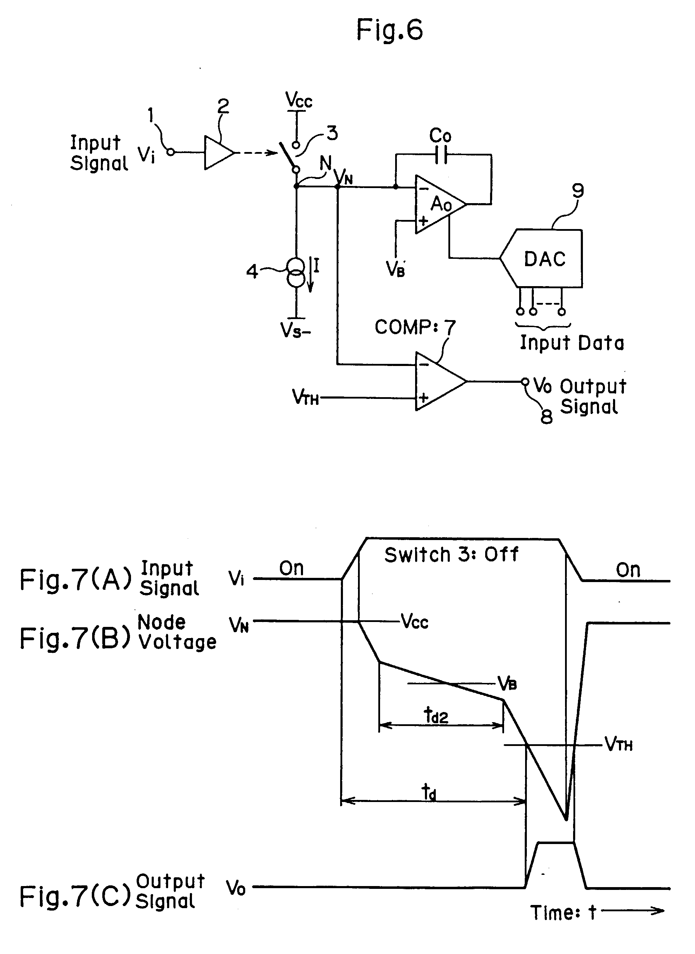

Referring to Fig. 6, there is shown another timing generator. This generator is similar to the timing generator shown in Fig. 2 except that the differential amplifiers A₁, A₂, etc. and the control circuit 5 are replaced with a differential amplifier A₀ and a D/A converter 9. The -saturated amplitude of the output signal from the amplifier A₀ is variable. The inverting input terminal of this amplifier is connected with the node N, while the non-inverting input terminal is applied with the third voltage V_{B} . A capacitor C₀ is connected between the inverting input terminal and the output terminal of the amplifier A₀. The combination of the amplifier A₀ and the capacitor C₀ forms a Miller integrator. The voltage at the inverting input terminal of the amplifier A₀ is compared with the fourth voltage V_{TH} by the comparator 7. The D/A converter 9 controls the amplitude of the output signal from the amplifier A₀ in response to the data supplied to the converter. This converter 9 forms a setting means for setting the equivalent input capacitance produced in the linear region of the amplifier according to the input data.

The operation of the timing generator shown in Fig. 6 is next described by referring to the timing chart of Fig. 7. When the switch 3 is turned on, the voltage V_{N} at the node N is equal to the first voltage V_{CC} (Fig. 7(B)). At this time, the output voltage from the amplifier A₀ is VL . When input signal pulse Vᵢ (Fig. 7(A)) is applied to the input terminal 1 and the switch 3 is turned off, the capacitor connected with the node N is electrically discharged by the constant current source 4. As a result, the voltage V_{N} at the node drops rapidly (Fig. 7(B)).

When the node voltage V_{N} differs greatly from the third voltage V_{B} , the output from the amplifier A₀ is saturated and maintained either at V_{L} (V_{N} > V_{B} ) or at V_{H} (V_{N} < V_{B} ). Therefore, the capacitive component C_{N} (equivalent input capacitance) connected to the node N is given by${\text{C}}_{\text{N}} {\text{= C}}_{\text{0}} {\text{+ C}}_{\text{S}}$ where C_{S} is the stray capacitance. The time Δt _{d1} taken for the node voltage V_{N} to change by Δ V_{N} is given by${\text{Δt}}_{\text{d1}} {\text{= (C}}_{\text{0}} {\text{+ C}}_{\text{S}} {\text{) Δ V}}_{\text{N}} \text{/ I}$ Where the node voltage V_{N} is close to the third voltage V_{B} , the amplifier A₀ operates linearly. The output voltage from the amplifier A₀ is varied from V_{L} to V_{H} by the mirror integration. At this time, electric charge C₀(V_{H} - V_{L} ) flows into the capacitor C₀ from the output of the amplifier A₀. This charge is supplied by the constant current source 4. The time required for this process is equivalently given by${\text{t}}_{\text{d2}} {\text{= C}}_{\text{0}} {\text{( V}}_{\text{H}} {\text{- V}}_{\text{L}} \text{) / I}$ The time taken for the node voltage V_{N} to change is increased accordingly. Therefore, when the input pulse Vᵢ is applied, the node voltage V_{N} begins to decrease. From equations (9) and (10), the time t_{d} taken for the voltage to pass through the threshold voltage V_{TH} for the comparator 7 is given by${\text{t}}_{\text{d}} {\text{= (C}}_{\text{0}} {\text{+ C}}_{\text{S}} {\text{) (V}}_{\text{CC}} {\text{- V}}_{\text{TH}} {\text{)/I + C}}_{\text{0}} {\text{( V}}_{\text{H}} {\text{- V}}_{\text{L}} \text{)/I}$ As can be seen from equation (11), the equivalent input capacitance of the Miller integrator can be set according to the input data and the delay time can be controlled by changing the saturated amplitude (V_{H} - V_{L} ) of the output signal from the amplifier A₀ by the output from the D/A converter 9. When the switch 3 is turned on again (Fig. 7(C)), the node voltage V_{N} is electrically charged through the switch 3 and returns to the potential V_{CC}.

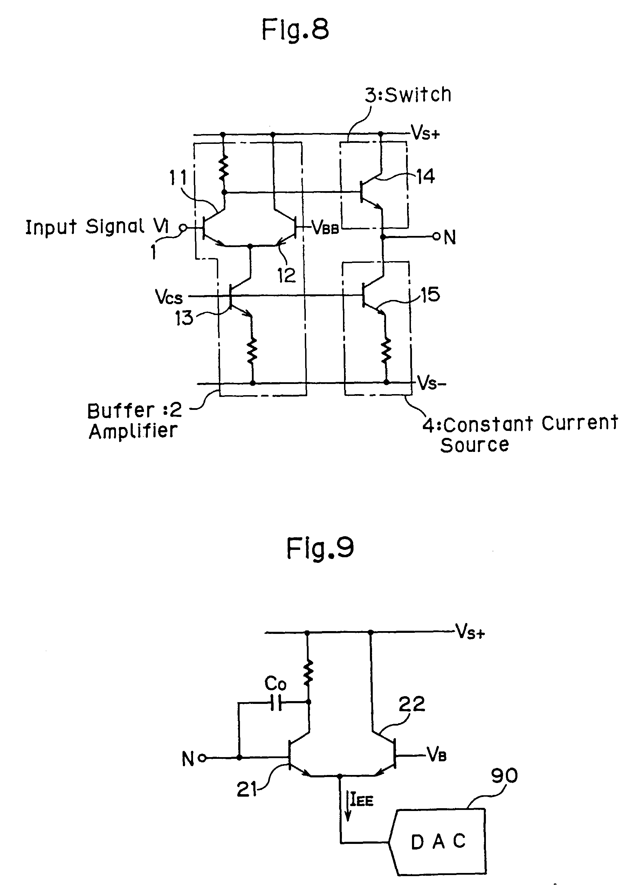

Referring to Fig. 8, there is shown a specific example of the combination of the buffer amplifier 2, the switch 3, and the constant current source 4 shown in Fig. 6. A differential amplifier is formed by transistors 11 and 12. A current-regulated circuit includes a transistor 13. A buffer amplifier 2 is formed by the differential amplifier and the current-regulated circuit. A transistor 14 whose base is controlled by the output signal from the buffer amplifier 2 forms a switch 3. Another current-regulated circuit including a transistor 15 forms the constant current source 4 which is controlled by voltage V_{CS} in the same way as the transistor 13.

Referring next to Fig. 9, there is shown a specific example of a circuit in which the amplitude of the output signal from the amplifier A₀ shown in Fig. 6 is controlled by a D/A converter 90 delivering an output current. The converter 90 controls the emitter current I_{EE} in transistors 21 and 22 which together form a differential amplifier. In this way, the amplitude of the output signal from the differential amplifier is varied. The output from the collector of the transistor 21 is fed back to the base via capacitance C₀, the base being connected to the node N.

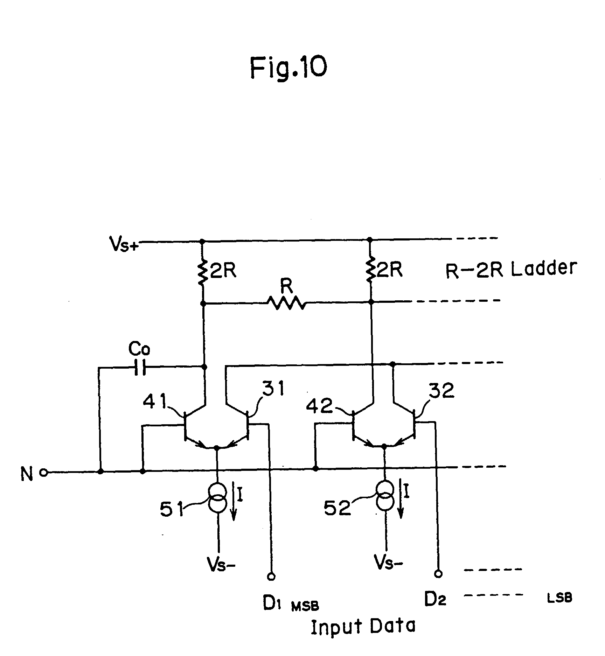

Referring to Fig. 10, there is shown another specific example which is identical in function with the circuit shown in Fig. 9. A part of a D/A converter producing an output voltage is used as the amplifier A₀. Transistors 31, 32, etc. turn on and off current switches respectively consisting of transistors 41, 42, etc. in response to input data D₁, D₂, etc. Thus, the current I supplied by constant current sources 51, 52, etc. is turned on and off. Digital signal is converted into analog form and appears at the collector of the transistor 41 by the action of a ladder network composed of resistors R and 2R. The transistor 41 forms the output stage of the D/A converter. Feedback is provided from the collector to the base of the transistor 41 via capacitance C₀ to produce a Miller capacitance. The base of the transistor 41 is connected with the node N shown in Fig. 6. In this configuration, the amplifier A₀ can be omitted. Hence, the configuration is made simple.

The timing generator shown in Fig. 6 has the following advantages in addition to the advantages offered by the apparatus shown in Fig. 2. Only one amplifier having the Miller effect is needed and, therefore, this generator is simpler in structure than the generator of Fig. 2 using plural amplifiers. Where plural amplifiers are employed, plural capacitors which are fabricated to a close tolerance must be used. Also, the output amplitudes from the plural amplifiers must lie within a narrow range. The timing generator shown in Fig. 6 is not required to satisfy these requirements. Furthermore, the apparatus occupies a small area, since neither plural amplifiers nor plural capacitors are needed. Moreover, high linearity can be easily obtained, because the accuracy is determined by the D/A converter used for the setting of the amount of delay. Consequently, it is adapted for the realization of a high resolution.

In the example shown in Fig. 6, Aᵢ consists of a differential amplifier, but Aᵢ is not limited to this kind of amplifier. Rather, any arbitrary amplifier having an inverting input terminal can be employed. Where high-speed operation is not needed, operational amplifiers may be utilized.

In the circuits shown in Figs. 9 and 10, the stray capacitance between the collector and the base of each transistor can be used as the capacitor C₀ in the same way as in the circuit of Fig. 5.

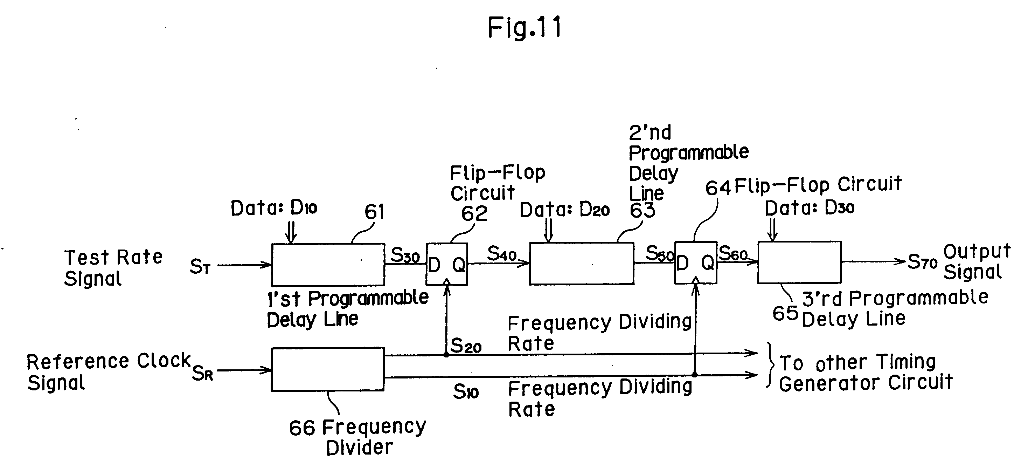

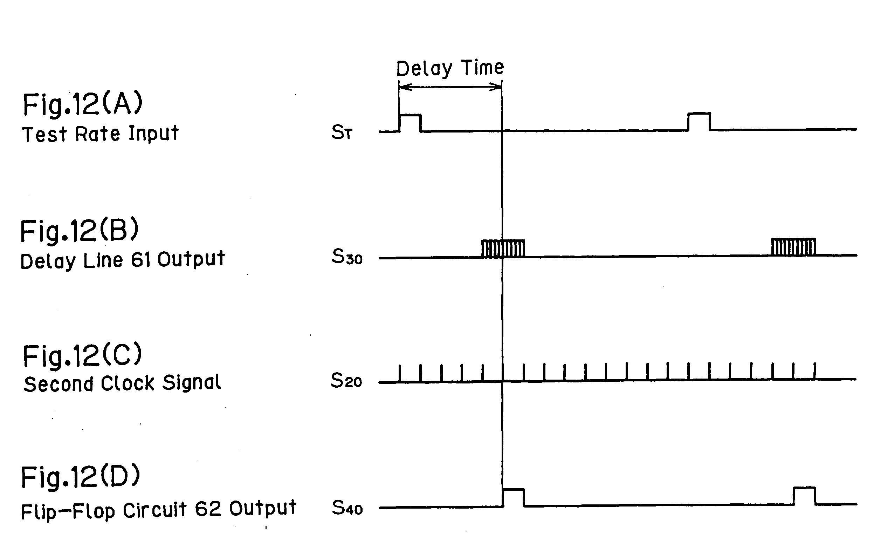

Referring to Fig. 11, there is shown a timing generator circuit fabricated by using the timing generators of the above examples. This circuit comprises a first programmable delay line 61, a first flip-flop circuit 62 which retains the output S₃₀ from the delay line 61, a second programmable delay line 63 connected to the output of the first flip-flop circuit 62, a second flip-flop circuit 64 which retains the output S₅₀ from the second delay line 63, a third programmable delay line 65 connected to the output of the second flip-flop circuit 64, and a frequency divider 66 receiving reference clock pulses S_{R} . The first delay line 61 delays test rate signal S_{T} synchronized with the reference clock pulses S_{R} of 1 GHz by a certain time corresponding to the first input data D₁₀, for example, with a time span of 1 ms and a resolution of 32 ns. The pulses forming the test rate signal S_{T} are spaced from each other by 20 ns. Note that the spacing is exaggerated in Fig. 12 for ease of understanding. The second delay line 63 delays the output S₄₀ from the first flip-flop circuit 62 by a given time corresponding to the second input data D₂₀, with a time span of 32 ns and a resolution of 1 ns. The third delay line 65 delays the output S₆₀ from the second flip-flop circuit 64 by a given time corresponding to the third input data D₃₀, with a resolution of 31.25 ps. The frequency divider 66 produces first clock pulses S₁₀ having the same frequency (1/1) as that of the reference clock pulses S_{R} and second clock pulses S₂₀ having a frequency one-thirty second (1/32) of the frequency of the reference clock pulses S_{R} . The first clock pulses S₁₀ trigger the second flip-flop circuit 64. The second clock pulses S₂₀ trigger the first flip-flop circuit 62. The first and second clock pulses S₁₀ and S₂₀ from the frequency divider 66 are also supplied to other timing generator (not shown) to generate pulses at different timing. In this example, the delay lines 61, 63, and 65 take the form of an IC incorporating the novel timing generators described above.

The operation of the timing generator of the construction described thus far now described by referring to the timing chart of Fig. 12. The frequency divider 66 produces the first clock pulses S₁₀ and the second clock pulses S₂₀ in response to the reference clock pulses S_{R} . The first clock pulses S₁₀ have the same frequency as that of the reference clock pulses S_{R} , while the frequency of the second clock pulses S₂₀ is one-thirty second (1/32) of the frequency of the reference clock pulses as mentioned above. The test rate signal S_{T} (Fig. 12(A)) is delayed (Fig. 12(B)) by a given time corresponding to the input data D₁₀ by means of the delay line 61. The output S₃₀ from the delay line 61 of a resolution of 32 ns is allowed to vary within ± 16 ns as described below. When the output is retained in the flip-flop circuit 62 in synchronism with the second clock pulses S₂₀ (Fig. 12 (C)), the errors are removed. Thus, complete retiming is done (Fig. 12(D)). The delay time of the delay line 61 with respect to the sample pulses S₂₀ is allowed to vary from [the instant of the previous sample pulse + the holding time of the flip-flip circuit 62] to [the instant of the next sample pulse - the set-up time of the flip-flip circuit 62].

The output S₄₀ from the flip-flop circuit 62 is delayed by the delay line 63 of a resolution of 1 ns within one period of the second clock pulses S₂₀. As a result, the output varies within ± 0.5 ns. When this output is retained in the flip-flop circuit 64 in synchronism with the first clock pulses S₁₀, the errors are eliminated, resulting in complete retiming, in the same way as in the above-described process. The delay time of the delay line 63 with respect to the sample pulses S₁₀ is allowed to vary within the same range as the above-described range for the delay line 61. In the case of an ECL, the set-up time and the holding time of the flip-flop circuit 64 are on the order of 200 ps.

The output S₆₀ from the flip-flop circuit 64 is delayed by the delay line 65 in response to the third input data D₃₀ at a higher resolution. As a result, the output S₇₀ from this timing generator is produced. Since the delay times of the delay lines 61 and 63 are readjusted by the flip-flop circuits 62 and 64, respectively, errors produced at each stage are not accumulative. Therefore, the linearity of the delay time from the test rate signal S_{T} to the output S₇₀ is very excellent.

In this structure of timing generator, the delay times introduced by the delay lines are readjusted by the flip-flop circuits. Consequently, the clocks can be delayed with a very high step linearity without depending on the error occurring at each step of delay line. Furthermore, the number of expensive ECL circuits can be reduced, since it is not necessary that all stages be composed of high-speed counters. Each flip-flop circuit can reset itself after producing an output signal. Then, the flip-flop circuit makes preparations for the next pulse. Also, each flip-flop circuit can consist of a monostable multivibrator, since delay is affected only by the leading edge of each pulse. Further, a register or memory may be used to hold data applied to each delay line.

In the timing generator circuit described in connection with Figs. 11 and 12, retiming is done for the two stages of delay lines. The invention is not limited to this scheme. Retiming may be done for one stage of delay line, for three stages of delay lines, and for any desired number of stages of delay lines, using clock pulses which are produced from a frequency divider to their respective stages. Also, retiming may be done up to the final stage of delay line. The frequency of the reference clock pulses, the time span and the resolution of each delay line, the subharmonic of the frequency divider, and other factors are not limited to the values used in the above example. Any other desired values may be employed.

As described thus far, in accordance with the present invention, a timing generator which is simple in structure, provides delay times of good linearity, and can be operated at a high speed can be accomplished.

That is, the Miller capacitor is electrically discharged with a constant current in the saturation region and in the linear region. The voltage developed at the inverting input terminal of the amplifier is compared with a constant value to produce a delay time. The delay time which is produced within the linear region where the inclination of the ramp waveform is mild is accurately varied in response to the input data. This enables the delay time to be set with a high accuracy and a high resolution. Since the voltage is compared with a constant value within the saturation region where the inclination of the ramp waveform is steep, the generator is made immune to noise even where the delay time is long. In addition, an inexpensive timing generator circuit having a high accuracy and a high resolution can be fabricated from the novel timing generator.

## Claims

1. A timing generator for receiving a first timing signal (Vᵢ) and producing a second timing signal (V₀) delayed with respect to the first timing signal by a variable time corresponding to input data, said timing generator comprising:
Miller amplifier means (A₀, A₁-Aₙ) having an inverting input terminal, an output terminal, and a capacitor (C₀, C₁-Cₙ) connected between the inverting input terminal and the output terminal;
a switch (3) connected between the inverting input terminal of the Miller amplifier means (A₀, A₁-Aₙ) and a first constant voltage source (V_{cc}), controlled by the first timing signal (Vᵢ);
a constant current source (4) which applies a constant current to the inverting input terminal of the Miller amplifier means (A₀, A₁-Aₙ) to electrically discharge the equivalent input capacitance of the Miller amplifier means (A₀, A₁-Aₙ) in the saturation region and in the linear region of the Miller amplifier means (A₀, A₁-Aₙ) ;
a setting means (5,9,90) for setting the equivalent input capacitance produced in the linear region of the Miller amplifier means (A₀, A₁-Aₙ) in response to the input data; and
a comparator (7) which compares the voltage produced at the inverting input terminal of the Miller amplifier means (A₀, A₁-Aₙ) with another constant voltage (V_{TH}) in the saturation region of the Miller amplifier means (A₀, A₁-Aₙ) after the linear region has been passed, whereby the comparator (7) produces said second timing signal delayed by said given variable time after the switch (3) is turned off by the first timing signal.

2. A timing generator according to claim 1,
characterized in that
one end of said switch (3) is connected with said first voltage source (V_{cc}) ;
said constant current source (4) is connected between the other end of said switch (3) and a second voltage source (Vₛ₋) ;
a third voltage source (V_{B}) whose output voltage is between the output voltages of the first voltage source (V_{cc}) and the second voltage source (Vₛ₋) is connected to a non-inverting input terminal of said Miller amplifier means (A₀) ;
said Miller amplifier means (A₀) produces an output signal whose saturated amplitude is variable,
a fourth voltage source (V_{TH}) produces a fourth voltage, which is between the voltages of the third voltage source (V_{B}) and the second voltage source (Vₛ₋);
said comparator (7) compares the voltage produced at the inverting input terminal of the Miller amplifier means (A₀) with the fourth voltage and produces the second timing signal delayed with respect to the first timing signal;
said setting means comprises a digital-to-analog converter (9,90) which controls the saturated amplitude of the output signal from the Miller amplifier means (A₀) in response to the input data; and
when the voltage at the node between the switch (3) and the constant current source (4) changes from the first voltage to the fourth voltage after the switch (3) is turned off by the first timing signal, the Miller amplifier means (A₀) sets its equivalent input capacitance produced in its linear region according to the input data and performs a Miller integration with the saturated amplitude of the output signal from the Miller amplifier means (A₀) in the neighborhood of the third voltage.

3. A timing generator according to claim 1,
characterized in that said Miller amplifier means is constituted by a plurality of amplifiers (A₁, ..., Aₙ), each having an inverting and a non-inverting input terminal, the non-inverting input terminals of all amplifiers being connected to a node (N) constituting the inverting input terminal of said Miller amplifier means; said capacitor is constituted by a plurality of capacitors (C₁-Cₙ), each connected between an inverting input terminal and an output terminal of a respective amplifier (A₁-Aₙ); and said setting means comprises a control circuit (5) which produces a plurality of control signals in response to the input data to turn on and off each amplifier (A₁, ..., Aₙ) respectively and varies the equivalent input capacitance produced in the linear region of said amplifiers (A₁, ..., Aₙ).

4. A timing generator circuit, comprising a plurality of delay lines (61, 63, 65) each comprising a timing generator according to any one of claims 1 to 3 and receiving a first timing signal and producing a second timing signal delayed with respect to the first timing signal by a variable time corresponding to input data, and a plurality of flip-flop circuits (62, 64) each holding the output signal from a delay line in response to clock pulses, wherein the plurality of delay lines (61, 63, 65) and said flip-flop circuits (62, 64) is connected to each other in series.

## Patentansprüche

1. Zeitgeber zum Abnehmen eines ersten Zeitsteuer- bzw. Taktsignals (Vi) und zum Erzeugen eines zweiten Zeitsteuer- bzw. Taktsignals (Vo), das gegenüber dem ersten Zeitsteuer- bzw. Taktsignal um eine variable Zeit entsprechend Eingangsdaten verzögert ist, welcher Zeitgeber umfaßt:
Miller-Verstärkereinheiten (Ao, A1 - An) mit einer invertierenden Eingangsklemme, einer Ausgangsklemme und einem zwischen die invertierende Eingangsklemme und die Ausgangsklemme geschalteten Kondensator (Co, C1 - Cn),
einen zwischen die invertierende Eingangsklemme der Miller-Verstärkereinheiten (Ao, A1 - An) und eine erste Konstantspannungsquelle (Vcc) geschalteten, durch das erste Zeitsteuer- bzw. Taktsignal (Vi) gesteuerten Schalter (3),
eine Konstantstromquelle (4), die einen konstanten Strom an die invertierende Eingangsklemme der Miller-Verstärkereinheiten (Ao, A1 - An) anlegt, um die Äquivalent-Eingangskapazität der Miller-Verstärkereinheiten (Ao, A1 - An) im Sättigungsbereich und im linearen Bereich der Miller-Verstärkereinheiten (Ao, A1 - An) elektrisch zu entladen,
eine Einstelleinheit (5, 9, 90) zum Einstellen der im linearen Bereich der Miller-Verstärkereinheiten (Ao, A1 - An) erzeugten Äquivalent-Eingangskapazität in Abhängigkeit von den Eingangsdaten und
einen Komparator (7), welcher die an der invertierenden Eingangsklemme der Miller-Verstärkereinheiten (Ao, A1 - An) erzeugten Spannung mit einer anderen konstanten Spannung (V_{TH}) im Sättigungsbereich der Miller-Verstärkereinheiten (Ao, A1 - An) nach dem Durchlaufen des linearen Bereichs vergleicht, wobei der Komparator (7) das zweite Zeitsteuer- bzw. Taktsignal erzeugt, das um die gegebene variable Zeit verzögert ist, nachdem der Schalter (3) durch das erste Zeitsteuer- bzw. Taktsignal geöffnet (worden) ist.

2. Zeitgeber nach Anspruch 1, dadurch gekennzeichnet, daß
eine Seite des Schalters (3) mit der ersten Spannungsquelle (Vcc) verbunden ist,
die Konstantstromquelle (4) zwischen die andere Seite des Schalters (3) und eine zweite Spannungsquelle (Vs-) geschaltet ist,
eine dritte Spannungsquelle (V_{B}), deren Ausgangsspannung zwischen den Ausgangsspannungen von erster Spannungsquelle (Vcc) und zweiter Spannungsquelle (Vs-) liegt, mit einer nichtlinvertierenden Eingangsklemme der Miller-Verstärkereinheit (Ao) verbunden ist,
die Miller-Verstärkereinheit (Ao) ein Ausgangssignal erzeugt, dessen Sätigungsamplitude variabel ist,
eine vierte Spannungsquelle (V_{TH}) eine vierte Spannung erzeugt, die zwischen den Spannungen von dritter Spannungsquelle (V_{B}) und zweiter Spannungsquelle (Vs-) liegt,
der Komparator (7) die an der invertierenden Eingangsklemme der Miller-Verstärkereinheit (Ao) erzeugte Spannung mit der vierten Spannung vergleicht und das gegenüber dem ersten Zeitsteuer- bzw. Taktsignal verzögerte zweite Zeitsteuer- bzw. Taktsignal erzeugt,
die Einstelleinheit einen Digital/Analog-Wandler (9, 90) umfaßt, welcher die Sättigungsamplitude des Ausgangssignals von der Miller-Verstärkereinheit (Ao) nach Maßgabe der Eingangsdaten regelt, und
dann, wenn die Spannung am Knotenpunkt zwischen dem Schalter (3) und der Konstantstromquelle (4) sich nach dem Öffnen des Schalters (3) durch das erste Zeitsteuer- bzw. Taktsignal von der ersten Spannung auf die vierte Spannung ändert, die Miller-Verstärkereinheit (Ao) ihre in ihrem linearen Bereich erzeugte Äquivalent-Eingangskapazität entsprechend den Eingangsdaten einstellt (sets) und eine Miller-Integration der Sättigungsamplitude des Ausgangssignals von der Miller-Verstärkereinheit (Ao) in der Nähe der dritten Spannung durchführt.

3. Zeitgeber nach Anspruch 1, dadurch gekennzeichnet, daß die Miller-Verstärkereinheit durch eine Anzahl von Verstärkern (A1, ..., An) mit jeweils einer invertierenden und einer nichtinvertierenden Eingangsklemme gebildet ist, die nichtinvertierenden Eingangsklemmen aller Verstärker mit einem die invertierenden Eingangsklemme der Miller-Verstärkereinheit bildenden Knotenpunkt (N) verbunden sind, der Kondensator durch eine Anzahl von Kondensatoren (C1 - Cn) gebildet ist, die jeweils zwischen eine invertierende Eingangsklemme und eine Ausgangsklemme eines betreffenden Verstärkers (A1 - An) geschaltet sind, und die Einstelleinheit eine Steuerschaltung (5) umfaßt, welche eine Anzahl von Steuersignalen in Abhängigkeit von den Eingangsdaten erzeugt, um jeden jeweiligen Verstärker (A1, ..., An) ein- und auszuschalten, und die im linearen Bereich der Verstärker (A1, ..., An) erzeugte Äquivalent-Eingangskapazität variiert.

4. Zeitgeberschaltung mit einer Anzahl von Verzögerungsleitungen (61, 63, 65), die jeweils einen Zeitgeber nach einem der Ansprüche 1 bis 3 aufweisen und ein erstes Zeitsteuer- bzw. Taktsignal abnehmen und ein zweites Zeitsteuer- bzw. Taktsignal erzeugen, das gegenüber dem ersten Zeitsteuer- bzw. Taktsignal um eine variable Zeit entsprechend Eingangsdaten verzögert ist, und mit einer Anzahl von Flipflopgliedern (62, 64), die jeweils das Ausgangssignal von einer Verzögerungsleitung in Abhängigkeit von Taktimpulsen halten bzw. zwischenspeichern, wobei die mehreren Verzögerungsleitungen (61, 63, 65) und Flipflopglieder (62, 64) miteinander in Reihe geschaltet sind.

## Revendications

1. Générateur de synchronisation destiné à recevoir un premier signal de synchronisation (Vᵢ) et à produire un second signal de synchronisation (Vₒ) retardé par rapport au premier signal de synchronisation d'un laps de temps variable correspondant à des données d'entrée, ledit générateur de synchronisation comprenant :
des moyens d'amplificateur de Miller (A₀, A₁-Aₙ) ayant une borne d'entrée inverseuse, une borne de sortie, et un condensateur (C₀, C₁-Cₙ) relié entre la borne d'entrée inverseuse et la borne de sortie ;
un commutateur (3) relié entre la borne d'entrée inverseuse des moyens d'amplificateur de Miller (A₀, A₁-Aₙ) et une première source de tension constante (V_{cc}), commandé par le premier signal de synchronisation (Vᵢ) ;
une source de courant constant (4) qui applique un courant constant à la borne d'entrée inverseuse des moyens d'amplificateur de Miller (A₀, A₁-Aₙ) pour décharger électriquement la capacité d'entrée équivalente des moyens d'amplificateur de Miller (A₀, A₁-Aₙ) dans la région de saturation et dans la région linéaire des moyens d'amplificateur de Miller (A₀, A₁-Aₙ) ;
des moyens de réglage (5, 9, 90) destinés à régler la capacité d'entrée équivalente produite dans la région linéaire des moyens d'amplificateur de Miller (A₀, A₁-Aₙ) en réponse aux données d'entrée ; et
un comparateur (7) qui compare la tension produite au niveau de la borne d'entrée inverseuse des moyens d'amplificateur de Miller (A₀, A₁-Aₙ) avec une autre tension constante (V_{TH}) dans la région de saturation des moyens d'amplificateur de Miller (A₀, A₁-Aₙ) après que la région linéaire a été dépassée, le comparateur (7) produisant ainsi ledit second signal de synchronisation retardé dudit laps de temps variable après que le commutateur (3) a été désactivé par le premier signal de synchronisation.

2. Générateur de synchronisation selon la revendication 1, caractérisé en ce que
une extrémité dudit commutateur (3) est reliée à ladite première source de tension (V_{cc}) ;
ladite source de courant constant (4) est reliée entre l'autre extrémité dudit commutateur (3) et une deuxième source de tension (Vₛ₋) ;
une troisième source de tension (V_{B}) dont la tension de sortie se situe entre les tensions de sortie de la première source de tension (V_{cc}) et la deuxième source de tension (Vₛ₋) est reliée à une borne d'entrée non-inverseuse desdits moyens d'amplificateur de Miller (A₀) ;
lesdits moyens d'amplificateur de Miller (A₀) produisent un signal de sortie dont l'amplitude saturée est variable,
une quatrième source de tension (V_{TH}) produit une quatrième tension, qui se situe entre les tensions de la troisième source de tension (V_{B}) et la deuxième source de tension (Vₛ₋) ;
ledit comparateur (7) compare la tension produite au niveau de la borne d'entrée inverseuse des moyens d'amplificateur de Miller (A₀) avec la quatrième tension et produit le second signal de synchronisation retardé par rapport au premier signal de synchronisation ;
lesdits moyens de réglage comprennent un convertisseur numérique/analogique (9, 90) qui commande l'amplitude saturée du signal de sortie provenant des moyens d'amplificateur de Miller (A₀) en réponse aux données d'entrée ; et
lorsque la tension au niveau du noeud entre le commutateur (3) et la source de courant constant (4) passe de la première tension à la quatrième tension après que le commutateur (3) a été désactivé par le premier signal de synchronisation, les moyens d'amplificateur de Miller (A₀) règlent sa capacité d'entrée équivalente produite dans sa région linéaire selon les données d'entrée et réalise une intégration de Miller avec l'amplitude saturée du signal de sortie provenant des moyens d'amplificateur de Miller (A₀) au voisinage de la troisième tension.

3. Générateur de tension selon la revendication 1, caractérisé en ce que lesdits moyens d'amplificateur de Miller sont constitués d'une pluralité d'amplificateurs (A₁, ..., Aₙ), chacun ayant une borne d'entrée inverseuse et une borne d'entrée non-inverseuse, la borne d'entrée non-inverseuse de tous les amplificateurs étant reliée à un noeud (N) constituant la borne d'entrée inverseuse desdits moyens d'amplificateur de Miller ; ledit condensateur est constitué d'une pluralité de condensateurs (C₁-Cₙ), chacun relié entre une borne d'entrée inverseuse et une borne de sortie d'un amplificateur respectif (A₁-Aₙ) ; et lesdits moyens de réglage comprennent un circuit de commande (5) qui produit une pluralité de signaux de commande en réponse aux données d'entrée pour activer et désactiver chaque amplificateur (A₁, ..., Aₙ) respectivement et modifie la capacité d'entrée équivalente produite dans la région linéaire desdits amplificateurs (A₁, ..., Aₙ).

4. Circuit générateur de synchronisation, comprenant une pluralité de lignes de retard (61, 63, 65) comprenant chacune un générateur de synchronisation selon l'une quelconque des revendications 1 à 3, et recevant un premier signal de synchronisation et produisant un second signal de synchronisation retardé par rapport au premier signal de synchronisation d'un laps de temps variable correspondant aux données d'entrée, et une pluralité de bascules bistables (62, 64) retenant chacune le signal de sortie provenant d'une ligne de retard en réponse à des impulsions d'horloge dans lequel la pluralité de lignes de retard (61, 63, 65) et lesdites bascules bistables (62, 64) sont reliées les unes aux autres en série.
